# EUROPEAN PATENT APPLICATION

(11) **EP 1 921 659 A2**
(43) Date of publication of application: **14.05.2008**
(21) Application number: 07115860.4
(22) Date of filing: 06.09.2007
(51) Int. Cl.: H01J 37/32

(54) **System and method for control of electromagnetic radiation in PECVD discharge processes**

(30) Priority: 09.11.2006 US 558270
(71) Applicant: Applied Materials, Inc., Santa Clara, CA 95054 (US)
(72) Inventor: Stowell, Michael W., Loveland, 80538 (US); Liehr, Michael, 36325, Feldatal (DE); Dieguez-Campo, Jose Manuel, 63457, Hanau (DE)
(74) Representative: Schickedanz, Willi

(57) **Abstract**

A system and method for coating a substrate with a film is described. One embodiment includes a process that provides a substrate on which to deposit a film; generates a plasma to produce radicals from a support gas; produces the radicals from the support gas; disassociates a precursor gas using the radicals; deposits material from the disassociated precursor gas on the substrate; and controls the amount of electromagnetic radiation to which the deposited material is exposed.

## Description

### FIELD OF THE INVENTION

The present invention relates to plasma enhanced chemical vapor deposition (PECVD) processes. In particular, but not by way of limitation, the present invention relates to systems and methods for controlling electromagnetic radiation during the PECVD process.

### BACKGROUND OF THE INVENTION

The process of depositing films using PECVD is well known and has been employed for many years. PECVD is used in several industries to deposit nonconductive and conductive films on a variety of substrates, including glass, semiconductor wafers, and plasma display panels.

These films vary widely in quality and chemistry. With regard to quality, films made of the same material can vary widely in density and purity. That is, depending upon the PECVD parameters, the type of PECVD system, and the system inputs, films can increase or decrease in quality.

In some cases, variations in film quality and chemistry are unintentional. But in other cases, film chemistry can deliberately be altered to create films with particular properties and characteristics. For example, PECVD process parameters such as radical density, pulsing frequency, duty cycle, gas pressure, and temperature can be varied to change film chemistry.

As the control over these process parameters improves, new applications become available for films and film quality for existing applications increases. Despite current process controls, the PECVD industry continues to search for new and better ways to control film chemistry. Accordingly, systems and methods are needed to more finely control film chemistry. Similarly, new films are needed that can be produced as a result of finely controlled film chemistry.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents and alternative constructions that fall within the spirit and scope of the invention as expressed in the claims.

A system and method for coating a substrate with a film is described. One embodiment includes a process that provides a substrate on which to deposit a film; generates a plasma to produce radicals from a support gas; produces the radicals from the support gas; disassociates a precursor gas using the radicals; deposits material from the disassociated precursor gas on the substrate; and controls the amount of electromagnetic radiation to which the deposited material is exposed.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawings wherein:
FIGURE 1 is a block diagram of a remote plasma source in accordance with conventional technology;
FIGURE 2 is a diagram of a remote plasma source in accordance with conventional technology in operation;
FIGURE 3 is an illustration of a dielectric film constructed in accordance with conventional processes;
FIGURE 4 is an illustration of a direct plasma source in accordance with conventional technology;
FIGURE 5 is an illustration of a dielectric film constructed in accordance with principles of one embodiment of the present invention;
FIGURE 6 is an illustration of a remote plasma source with an electromagnetic radiation assist device;
FIGURE 7 is an illustration of a direct plasma source that includes a radiation assist device;
FIGURE 8 is an illustration of a direct plasma source in accordance with one embodiment of the present invention;
FIGURE 9 is an illustration of a thin film constructed in accordance with one embodiment of the present invention;
FIGURE 10 is an illustration of a thin film constructed in accordance with another embodiment of the present invention;
FIGURE 11A illustrates a power waveform that can be used to generate additional ultraviolet radiation;
FIGURE 11 B illustrates the ultraviolet radiation that results from the power waveform of FIGURE 11A;
FIGURE 12A illustrates a power wave form that can be used to generate additional ultraviolet radiation; and
FIGURE 12B illustrates the ultraviolet radiation that results from the wave form of FIGURE 12A.

### DETAILED DESCRIPTION

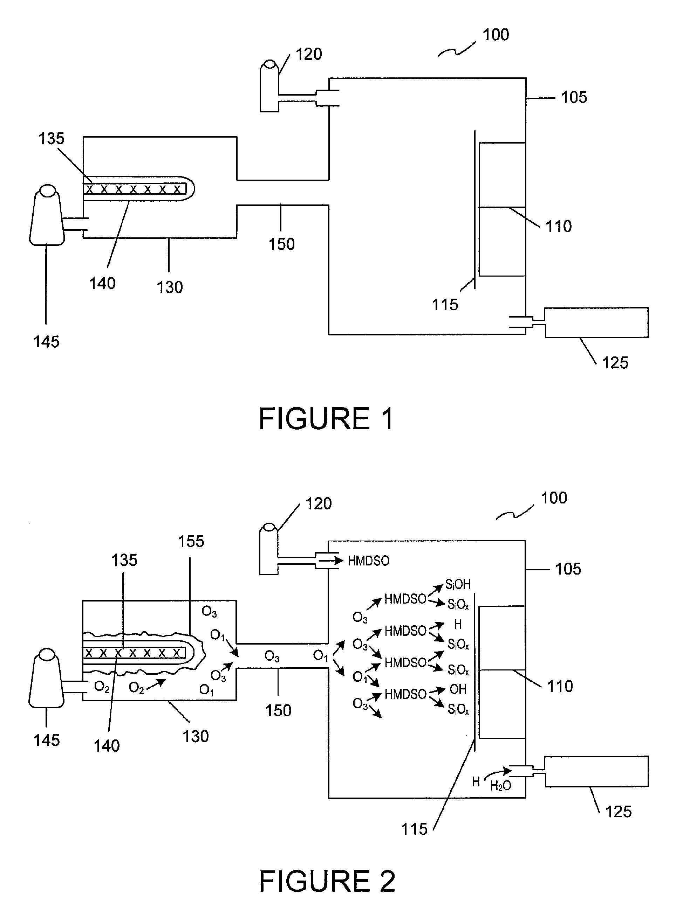

Referring now to the drawings, where like or similar elements are generally designated with identical reference numerals throughout the several views, and referring in particular to FIGURE 1, it is a remote PECVD system 100 in accordance with conventional technology. This system includes a process chamber 105, a substrate support 110, a substrate 115 on which a film will be deposited, a precursor gas source 120, a gas pump 125, a plasma chamber 130, an antenna 135, a protective sheath 140, a supporting gas source 145, and a connecting neck 150 that connects the plasma chamber 130 with the process chamber 105. Remote plasma systems of this type are generally known in the art and not described in full detail herein.

Referring now to Figure 2, it shows the remote PECVD system 100 of Figure 1 in operation. This PECVD system 100 is configured to deposit a dielectric layer of SiO₂ onto the substrate 115. To deposit this dielectric layer, the precursor gas, HMDSO, is disassociated using O₃ and O₁ ions. These O₃ and O₁ ions are created by exposing the supporting gas, O₂, to electrons emitted by the antenna 135 and to ion collisions. Generally, the antenna 135 is powered by an RF source, but it could also be driven by other power sources.

The electrons emitted from the antenna 135 causes the O₂ gas to ionize and form a plasma 155. This plasma 155 causes a cascade reaction, thereby forming more ions and fractionalized O₂ gas (radicals). These radicals then travel through the neck 150 connecting the remote plasma chamber 130 to the plasma chamber 105. Once in the plasma chamber 105, the radicals collide with the HMDSO molecules, breaking them into SiOx, H, OH, etc.

For this embodiment, a perfect film would include only SiO₂. However, waste particles such as OH, H₂O and SiOH form during the disassociation and deposition process. And these particles also deposit upon the substrate and growing film. When the growing film is SiO₂, these impurities reduce its dielectric properties but may also introduce flexibility into the film. Similar changes result in other types of films.

Most of the impurities produced during the PECVD process are actually pumped out of the process chamber rather than deposited upon the substrate. However, in most processes, enough impurities deposit upon the substrate to significantly change the film chemistry.

Those of skill in the art will understand that a remote plasma source can be used for other thin films besides the dielectric SiO₂ layer. This process is shown for illustration purposes only.

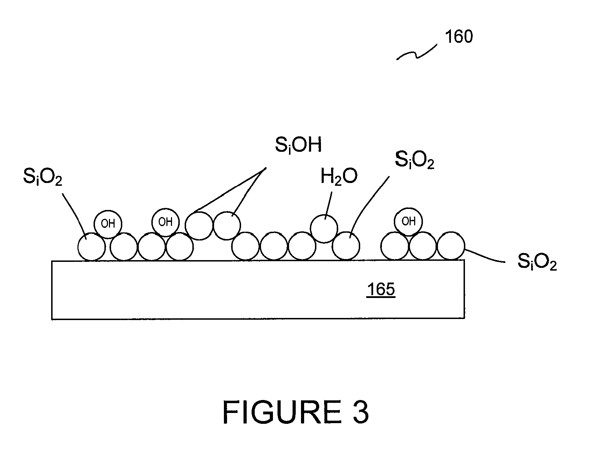

Referring now to Figure 3, it illustrates a SiO₂ film 160 produced by the remote PECVD system described in Figure 2. This figure illustrates a substrate layer and the film deposited thereon. Most of the thin film is formed of SiO₂. However, the film also includes certain impurities such as OH, H₂O and SiOH. These impurities tend to slowly combine in the matrix with un-decomposed materials from the precursor, fractionalization processes materials and also unsatisfied bonds in the matrix increasing the films density, this results in increased film stress that lead to cracking and delamination as the film ages. Moreover, the film does not have a uniform density. That is, the deposited material is not deposited evenly and leaves gaps. Moreover, as the film cools, some of the H₂O molecules eventually escape, leaving gaps where the H₂O molecules were originally located.

These types of flaws in thin films are found in nearly all film chemistries and are not limited to SiO₂ dielectrics. And although these films are functional for some purposes, these flaws limit the film's ability and life span in many instances. For example, these impurities and gaps cause thin films to crack and reduce their desired electrical properties.

In some instances, films may actually benefit from a carefully added amount of impurities. But this process of adding impurities must be carefully controlled or the film quality will suffer significantly.

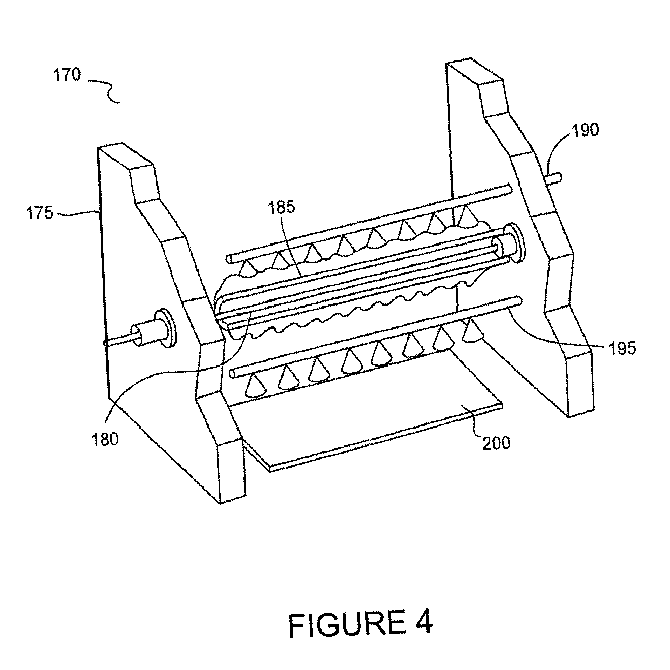

Referring now to Figure 4, it illustrates a direct PECVD system 170 in accordance with conventional technology. In this type of PECVD system, the plasma chamber and process chambers are combined. Otherwise, the direct PECVD system works similarly to the remote PECVD system.

This embodiment of a conventional PECVD system includes a process chamber 175, an antenna 180, a dielectric sheath 185, a supporting gas supply 190, a precursor gas supply 195, and a substrate 200. Although not shown, this system could also include a substrate support. Again, this type of PECVD system is well known in the art and not described in great detail herein.

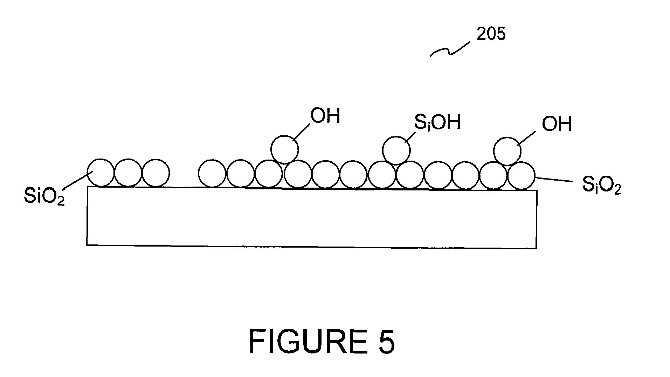

Although this PECVD system should work almost identically to the remote PECVD system shown in Figure 1, it has been discovered that, for certain film chemistries, the direct PECVD system produces a somewhat higher quality film than does the remote PECVD system. For example, Figure 5 illustrates a dielectric film 205 produced by a direct PECVD system. While this film still includes impurities and gaps that reduce the overall quality of the film, the number of impurities and gaps is decreased.

It was recently discovered that part of the reason for this increase in film quality was due to electromagnetic radiation, and in particular ultraviolet radiation, radiated outward from the plasma formed around the antenna. In a remote PECVD system, the electromagnetic radiation was blocked from reaching the substrate and the growing film. But in the direct PECVD system, the radiation from the plasma could directly bombard the substrate and the growing film. This bombardment was discovered to significantly affect the chemistry of the growing film. In some instances, the electromagnetic radiation bombardment enhanced the quality of the film. However, in other cases, the electromagnetic radiation bombardment could actually disrupt the growth of the film.

As previously discussed, the PECVD industry is always searching for new and better ways to control the PECVD process and more finely tune the chemistry of the deposited films. And conventionally, the PECVD industry controlled process parameters such as radical density, pulsing frequency, duty cycle, gas pressure and temperature. In accordance with embodiments of the present invention, the additional process parameter of electromagnetic radiation can also be controlled.

By controlling the amount of electromagnetic radiation, including UV radiation, to which the growing film is exposed, film chemistry can be more finely controlled. Moreover, the substrate can be preconditioned by controlling the amount of electromagnetic radiation to which the substrate is exposed prior to depositing the film. In both instances, the amount of electromagnetic radiation can be significantly and quickly varied during the course of film production. Alternatively, the amount of electromagnetic radiation can be set for a desired film chemistry. This ability to vary electromagnetic radiation during the film production allows film chemistry to be finely controlled and changed as the film is grown.

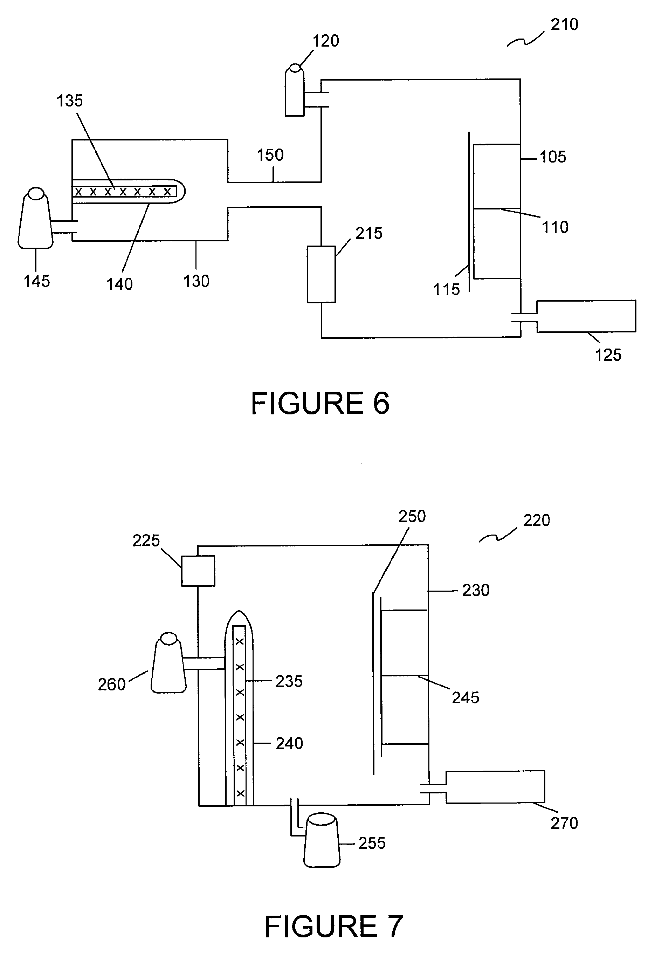

Referring now to Figure 6, this is one embodiment of a PECVD system 210 that includes electromagnetic radiation control. This system is a remote plasma system similar to the system shown in Figure 1. This system includes the plasma chamber 130 and the process chamber 105 separated by a connecting neck 150. Typically, this type of system blocks electromagnetic radiation produced by the plasma from reaching the substrate. But this system uses a radiation assist device 215 added to the process chamber to introduce radiation to the growing film.

In one embodiment, this radiation assist device 215 is an ultraviolet source that is controlled by a computer or manually by a user. The UV source output could be linked to any of the process parameters commonly used to control film quality. For example, the UV source could be linked to radical density so that the UV source is at a high output level when radical density is at its lowest point and UV could be at its lowest point when radical density is at its highest point. Those of skill in the art could determine how to adjust the process parameters and the UV output to achieve their unique, desired film chemistries.

Figure 7 illustrates a direct plasma source that includes a radiation assist device 225. This direct plasma system is similar to the system shown in Figure 4. It includes the process chamber 230, the antenna 235, the dielectric sheath 240 protecting the antenna, the substrate support 245, the substrate 250, a supporting gas supply 255, a precursor gas supply 260, and an exhaust pump 270.

In this embodiment it is assumed that the electromagnetic radiation radiated from the plasma around the antenna 235 is not sufficient to achieve the film properties desired. Accordingly, an assist device 225 is added to provide extra electromagnetic radiation as needed. This electromagnetic radiation assist device 225 could also be manually controlled or computer controlled and timed to operate with other conventional process parameters.

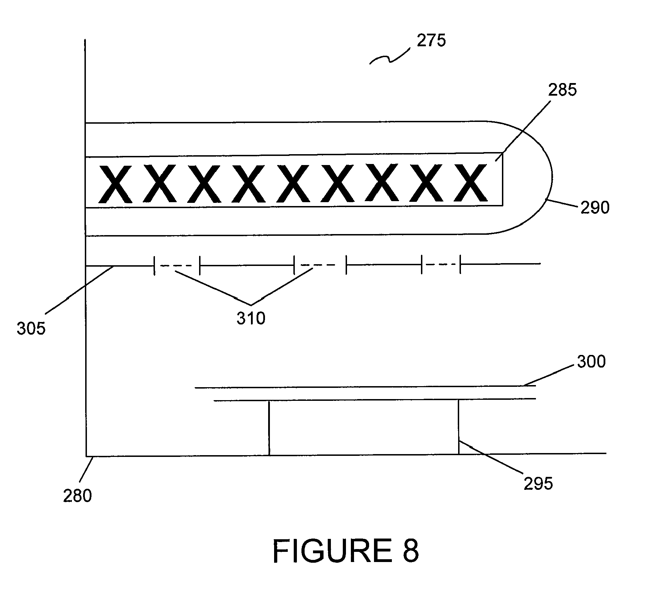

Figure 8 illustrates a portion of a direct PECVD system 275 in accordance with the present invention. This diagram illustrates a cutaway of the process chamber 280. In particular, it illustrates the process chamber walls 280, the antenna 285, the dielectric sheath 290 protecting the antenna, the substrate support 295, and the substrate 300. This embodiment also illustrates a radiation shield 305 with variable shutters 310 to restrict apertures in the shield. The general operation of a process chamber and a PECVD systems - not including the radiation shield - is known in the art and not described further.

This embodiment assumes that the electromagnetic radiation produced by the plasma surrounding the antenna 285 is sufficient to sufficiently alter film chemistry. In fact, this embodiment assumes that at times the electromagnetic radiation produced by the plasma may be more than is needed to adequately alter film chemistry. Accordingly, the shutters 310 in this embodiment can be opened, restricted, or closed as the process parameters demand. The shutters 310 are designed to block the passage of electromagnetic radiation. As with the previously described radiation sources, the shutters can be linked to other process parameter controls to finally control film chemistry. Shutters can include any device that restricts electromagnetic radiation, including UV radiations.

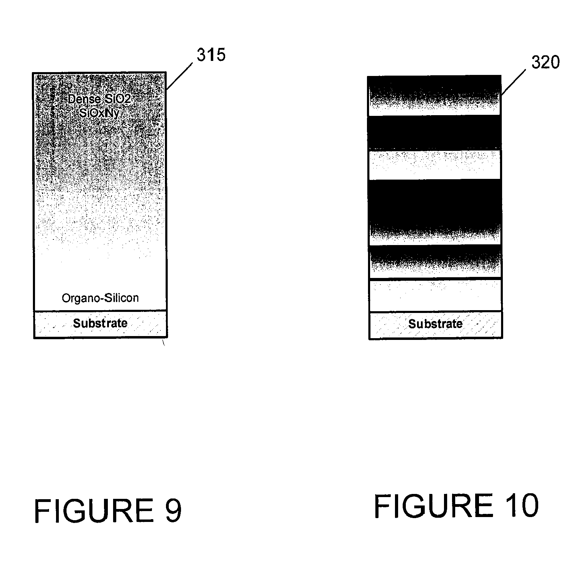

Figures 9 and 10 illustrate two film chemistries that can be produced by controlling the amount of electromagnetic radiation that bombards the growing film. In Figure 9, the electromagnetic radiation is increased as the film 315 is grown. For example, the shutters shown in Figure 8 could be slowly opened as the film 315 is grown. The resulting film chemistry becomes more dense as the film grows outward. For a dielectric layer formed of SiO₂, this type of increasing density film results in an organo-silicon layer nearest the substrate and a dense SiO₂ layer on the outer portions of the film. This type of film chemistry is desirable in some cases so that the film adheres to the underlying substrate adequately.

Figure 10 illustrates another type of Film 320 that can be generated by controlling the amount of radiation that bombards the film. In this film 320, the film density varies from less dense to dense, back to less dense. This type of chemistry produces desirable electrical properties in certain instances.

In some instances, control of electromagnetic radiation alone can produce the desired film chemistries. But as previously described, in other instances, the electromagnetic radiation is controlled in conjunction with other process parameters such as radical density, power modulation, duty cycle, pulsing frequency, pulse shape, gas pressure, and radical density. In particular, as previously described, one novel method of using UV control involves linking the amount of UV at the film to the radical density.

For example, if a SiO₂ dielectric layer is being deposited, the UV could be linked to the density of O₁ and O₃ radicals at a particular point in time. As the radical density decreases, the amount of UV could be increased to prepare the surface of the film as the deposition rate lowers, and as the radical density increases, the UV could be reduced to allow more material to be deposited unencumbered by added energy sources.

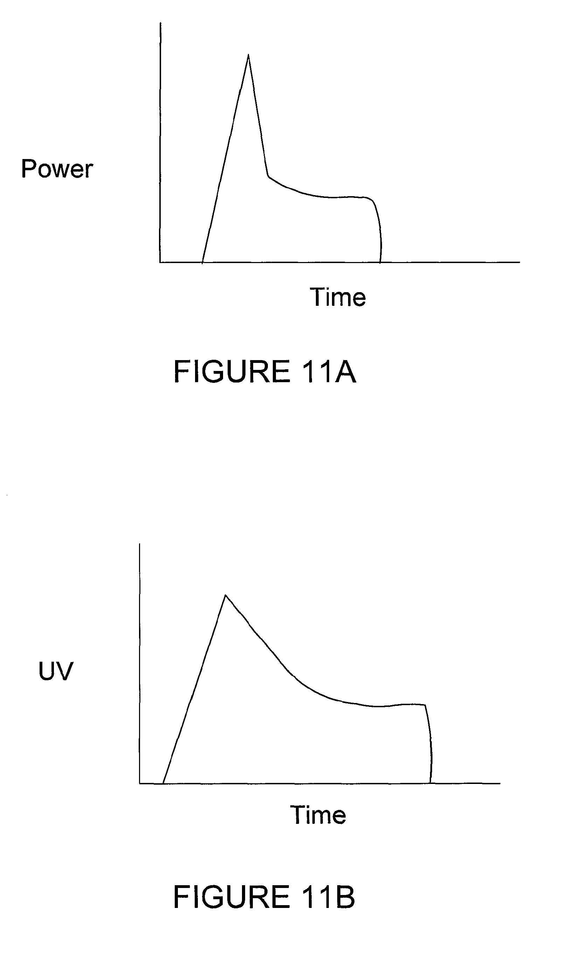

Referring now to Figures 11 A and 11 B, they illustrates a power waveform that can be used to generate additional ultraviolet radiation. Generally, the PECVD process is driven by applying microwave or RF frequency power signals to the antenna within the process chamber. In accordance with one embodiment of the present invention, the power signal can be modified to generate more or less ultraviolet radiation. In this embodiment, the power applied to the PECVD process is initially spiked. Although the spike adds little to the overall power delivered to the PECVD process, the power spike generates significant amounts of additional ultraviolet radiation. This additional ultraviolet radiation is illustrated in Figure 11 B.

Notably, embodiments that use power waveform contouring to control the amount of ultraviolet radiation need not include any type of radiation shield. Although some embodiments of the present invention can also include a radiation shield.

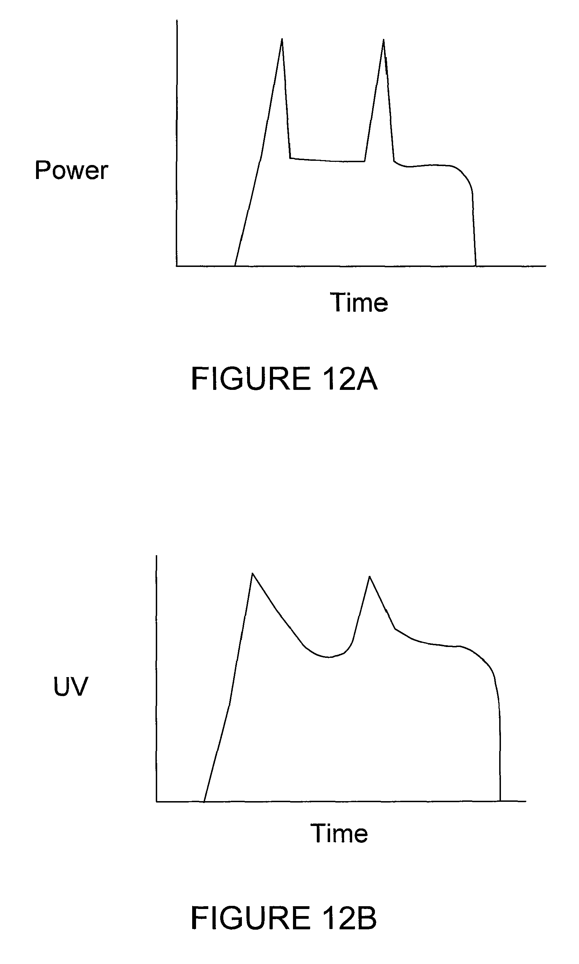

Figures 12A and 12B, they illustrate alternate waveforms used to generate additional ultraviolet radiation. In this embodiment, the power is spiked twice during a single pulse. These spikes do little to the overall power delivered to the PECVD process, but significantly increase the amount of ultraviolet radiation produced.

Additionally, controlling the contour of the pulse shape also enables control over the wavelength of the produced ultraviolet radiation. And in some embodiments, the wavelength is controlled independently of the amount of ultraviolet radiation produced.
In conclusion, the present invention provides, among other things, a system and method for PECVD and controlling the PECVD process. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

1. A method for coating a substrate with a film, the method comprising:
providing a substrate on which to deposit a film;
generating a plasma to produce radicals from a support gas;
producing the radicals from the support gas;
disassociating a precursor gas using the radicals;
depositing material from the disassociated precursor gas on the substrate; and
controlling the amount of electromagnetic radiation to which the deposited material is exposed.

2. The method of claim 1, wherein controlling the amount of electromagnetic radiation to which the deposited material is exposed comprises:
blocking ultraviolet radiation emitted by the plasma.

3. The method of claim 1, wherein controlling the amount of electromagnetic radiation to which the deposited material is exposed comprises:
reducing an aperture opening between the plasma and the deposited material.

4. The method of claim 1, wherein controlling the amount of electromagnetic radiation to which the deposited material is exposed comprises:
increasing ultraviolet radiation generated.

5. The method of claim 1, wherein generating a plasma to produce radicals from a support gas comprises:
providing a power signal to generate the plasma.

6. The method of claim 5, wherein providing a power signal to generate the plasma comprises:
spiking the power signal to thereby increase the amount of ultraviolet radiation.

7. The method of claim 6, wherein spiking the power signal to thereby increase the amount of ultraviolet radiation comprises:
controlling the timing of spiking the power signal to thereby control the increase in the amount of ultraviolet radiation.

8. The method of claim 1, wherein providing a power signal to generate the plasma comprises:
varying the power signal to thereby increase the amount of ultraviolet radiation.

9. The method of claim 1, wherein providing a power signal to generate the plasma comprises:
varying the power signal to thereby vary the wavelength of the ultraviolet radiation.

10. The method of claim 1, wherein controlling the amount of electromagnetic radiation to which the deposited material is exposed comprises:
varying the amount of ultraviolet radiation to which the deposited material is exposed in accordance with the density of radicals.

11. The method of claim 10, wherein varying the amount of ultraviolet radiation to which the deposited material is exposed comprises:
increasing the amount of ultraviolet radiation to which the deposited material is exposed when the density of radicals is reduced.

12. The method of claim 10, wherein varying the amount of ultraviolet radiation to which the deposited material is exposed comprises:
decreasing the amount of ultraviolet radiation to which the deposited material is exposed when the density of radicals is increased.

13. The method of claim 8, wherein controlling the amount of electromagnetic radiation to which the deposited material is exposed comprises:
varying the amount of ultraviolet radiation to which the deposited material is exposed in accordance with variations to a power signal used to produce the plasma.

14. A PECVD system comprising:
a plasma chamber;
an antenna;
a substrate support;
a electromagnetic radiation restrictor positioned between the antenna and the substrate support, the restrictor having a controllable aperture; and
a controller configured to control the controllable aperture.

15. The PECVD system of claim 14, wherein the controller comprises:
a computer configured to vary the size of the aperture according to at least one PECVD process parameter.

16. The PECVD system of claim 14, wherein the controller comprises:
a computer configured to vary the size of the aperture according to a density of radicals produced in the plasma chamber.

17. The PECVD system of claim 14, wherein the controller comprises:
a computer configured to vary the size of the aperture according to variations in a power signal applied to the antenna.

18. A method of producing a film, the method comprising:
initiating a PECVD process to deposit a film on a substrate; and
varying the amount of ultraviolet radiation to which the film is exposed during growth.

19. The method of claim 18, wherein varying the amount of ultraviolet radiation to which the film is exposed during growth comprises:
mechanically varying the amount of ultraviolet radiation to which the film is exposed during growth.

20. The method of claim 18, wherein varying the amount of ultraviolet radiation to which the film is exposed during growth comprises and wherein a plasma used during the PECVD process generates a first amount ultraviolet radiation comprises:
blocking a first portion of the first amount of ultraviolet radiation from reaching the film.

21. The method of claim 20, wherein varying the amount of ultraviolet radiation to which the film is exposed during growth comprises and wherein a plasma used during the PECVD process generates a first amount ultraviolet radiation:
blocking less than the first portion of the first amount of ultraviolet radiation blocked from reaching the film.

22. The method of claim 18, wherein varying the amount of ultraviolet radiation to which the film is exposed during growth comprises:
varying the amount of ultraviolet radiation to which the film is exposed during growth by contouring a power waveform used to drive the PECVD process.

23. A method of producing a film, the method comprising:
initiating a PECVD process to deposit a film on a substrate;
generating ultraviolet radiation, wherein the film is exposed to the ultraviolet radiation;
varying the wavelength of the ultraviolet radiation.

24. The method of claim 23, wherein varying the wavelength of the ultraviolet radiation comprises:
contouring a power waveform used to drive the PECVD process.
